(19) Europäisches Patentamt
European Patent Office
Office européen des brevets

(11) Veröffentlichungsnummer : **0 040 721**
**B1**

(12) # EUROPÄISCHE PATENTSCHRIFT

(45) Veröffentlichungstag der Patentschrift : **21.03.84**

(51) Int. Cl.³ : **C 07 F 9/50**, C 08 F 2/50, G 03 C 1/68// C08G63/52

(21) Anmeldenummer : **81103417.2**

(22) Anmeldetag : **06.05.81**

(54) **Acylphosphinverbindungen und ihre Verwendung.**

(30) Priorität : **27.05.80 DE 3020092**

(43) Veröffentlichungstag der Anmeldung : **02.12.81 Patentblatt 81/48**

(45) Bekanntmachung des Hinweises auf die Patenterteilung : **21.03.84 Patentblatt 84/12**

(84) Benannte Vertragsstaaten : **BE CH DE FR GB IT LI NL**

(56) Entgegenhaltungen :
**EP-A- 0 007 086**
**EP-A- 0 007 508**
**US-A- 3 668 093**
**Chemical Abstracts Band 78, Nr. 17 30. April 1973 Columbus, Ohio, USA H. KUNZEK et al. "Reaction of acid chlorides with trimethylsilydiphenylphosphine. II. Preparation and properties of aromatic acid phosphides" Seite 499, Spalte 1, abstract nr. 111448g**

(73) Patentinhaber : **BASF Aktiengesellschaft**
**Carl-Bosch-Strasse 38**
**D-6700 Ludwigshafen (DE)**

(72) Erfinder : **Henne, Andreas, Dr.**
**Bruesseler Ring 34**
**D-6700 Ludwigshafen (DE)**
Erfinder : **Hesse, Anton, Dr.**
**Peter-Nickel-Strasse 15**
**D-6946 Lutzelsachsen (DE)**
Erfinder : **Buethe, Ingolf, Dr.**
**Am Wasserturm 1**
**D-6737 Boehl-Iggelheim (DE)**
Erfinder : **Heil, Guenter, Dr.**
**Dirmsteiner Weg 41**
**D-6700 Ludwigshafen (DE)**

**EP 0 040 721 B1**

Anmerkung : Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Jouve, 18, rue St-Denis, 75001 Paris, France

## Acylphosphinverbindungen und ihre Verwendung

Die vorliegende Erfindung betrifft neue Acylphosphinverbindungen, Verfahren zu ihrer Herstellung und ihre Verwendung als Photoinitiatoren in photopolymerisierbaren Massen.

Es sind bereits eine Reihe von Photoinitiatoren verschiedener Strukturen bekannt, z. B. Benzildimethylketal (DE-OS 22 61 383), Benzoinäther (DE-OS 16 94 149), Thioxanthone (DE-OS 20 03 132) u. a. In der US-PS 3 668 093 sind ferner Aroylphosphine als Photoinitiatoren beschrieben.

Photopolymerisierbare Massen, die mit derartigen Initiatorsystemen, insbesondere auch mit den in der US-PS 3 668 093 beschriebenen Aroylphosphinen gehärtet werden, zeigen eine unerwünschte Vergilbung, die eine Verwendung dieser Systeme auf hellen (bzw. weißen) Flächen oder als Überzug für farbtreue Abbildungen unbrauchbar macht. Außerdem zeigen diese Verbindungen in acrylatlacken nur geringe Härtungsgeschwindigkeiten. Nachteilig ist auch, daß diese Verbindungen sich in Gegenwart von Aminbeschleunigern zersetzen. Überraschenderweise wurde nun gefunden, daß die beschriebenen Nachteile der Acylphosphine der US-PS 3 668 093 vermieden werden, wenn der Arylrest der Aroylgruppe in den beiden zur Carbonylgruppe benachbarten Stellungen substituiert ist. Solche Verbindungen waren bisher nicht bekannt.

Gegenstand der Erfindung sind Acylphosphin-Verbindungen der allgemeinen Formel (I)

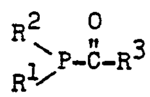

(I)

worin

$R^1$ für einen geradkettigen oder verzweigten Alkylrest mit 1 bis 6 Kohlenstoffatomen, den Cyclohexyl-, cyclopentyl-, Phenyl-, einen Naphthyl-, einen halogen-, $C_1$ bis $C_4$-alkyl- oder $C_1$ bis $C_4$-alkoxylsubstituierten Phenyl- oder Naphtylrest oder einen S- oder N-haltigen fünf- oder sechsgliedrigen heterocyclischen Ring steht,

$R^2$ die Bedeutung von $R^1$ hat, wobei $R^1$ und $R^2$ untereinander gleich oder verschieden sein können oder $R^1$ und $R^2$ miteinander zu einem Ring verknüpft sind, der 4 bis 10 Kohlenstoffatome enthält und durch 1 bis 6 weitere Alkylreste mit je 1 bis 4 Kohlenstoffatomen substituiert sein kann sowie 1 oder 2 ankondensierte Benzolringe besitzen kann und

$R^3$ für einen mindestens zweifach substituierten Phenyl-, Pyridyl-, Furyl-, Pyrrolyl- oder Thienylrest steht, der mindestens an den beiden zur Verknüpfungsstelle mit der Carbonylgruppe benachbarten Kohlenstoffatomen die Substituenten A und B trägt, die untereinander gleich oder verschieden sein können und für 1 bis 6 Kohlenstoffatome enthaltende Alkyl-, Alkoxy- oder Alkylthioreste, 3 bis 7 Kohlenstoffatome enthaltende Cycloalkylreste, Phenylreste oder Halogen-, vorzugsweise Chlor- oder Brom-Atome stehen, oder $R^3$ für einen mindestens in den 2,8-Stellungen durch A und B substituierten α-Naphthylrest oder mindestens in den 1,3-Stellungen durch A und B substituierten β-Naphthylrest oder für die Gruppierung

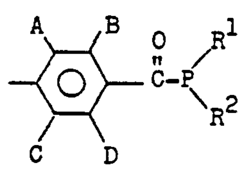

steht, wobei die Reste A, B, C und D untereinander gleich oder verschieden sind und C und D die gleiche Bedeutung haben wie A und B.

Bezüglich der allgemeinen Formel (I) der erfindungsgemäßen Acylphosphine-Verbindungen ist im einzelnen folgendes auszuführen :

$R^1$ kann sein ein geradkettiger oder verzweigter Alkylrest mit 1 bis 6 Kohlenstoff-Atomen wie Methyl, Äthyl, i-Propyl, n-Propyl, n-Butyl, sec.-Butyl, iso-Butyl, t-Butyl, Amyl, n-Hexyl ; der Cyclopentyl- oder Cyclohexylrest ; der Phenyl- oder ein Naphthylrest ; ein halogensubstituierter beispielsweise Chlor-, Brom- oder Fluor-substituierter Phenyl- oder Naphthylrest, wie z. B. Mono- oder Dichlorphenyl, ein $C_1$ bis $C_4$-alkylsubstituierter Phenyl- oder Naphthylrest, wie Methylphenyl, Äthylphenyl, Isopropylphenyl, tert.-Butylphenyl, ein $C_1$ bis $C_4$-alkoxysubstituierter Phenyl- oder Naphthylrest, wie Methoxyphenyl, Äthoxyphenyl, ein S- oder N-haltiger fünf- oder sechsgliedriger heterocyclischer Ring, wie z. B. der Thienyl-, Pyridyl-Pyrrolyl- oder Furylrest ;

$R^3$ kann beispielsweise ein 2,6-Dimethylphenyl-, 2,6-Dimethoxyphenyl-, 2,6-Dichlorphenyl, 2,6-Dibromphenyl-, 2-Chlor-6-methoxyphenyl-, 2-Chlor-6-methylthio-phenyl-, 2,4,6-Trimethylphenyl-, 2,4,6-Trimethoxyphenyl-, 2,3,4,6-Tetramethylphenyl-, 2,6-Dimethyl-4-tert.butyl-phenyl-, 1,3-Dimethylnaphthalin-2-, 2,8-Dimethylnaphthalin-1, 1,3-Dimethoxynaphthalin-2-, 1,3-Dichlornaphthalin-2, 2,8-Dimethoxy-

naphthalin-1-, 2,4,6-Trimethylpyridin-3-, 2,4-Dimethoxy-furan-3 oder ein 2,4,5-Trimethylthiophen-3-Rest sein.

Als Beispiele für die erfindungsgemäßen, als Photoinitiatoren geeigneten Acylphosphinverbindungen seien genannt :

2,6-Dimethylbenzoyl-diphenylphosphin
2,6-Dimethoxybenzoyl-diphenylphosphin
2,4,6-Trimethylbenzoyl-diphenylphosphin
2,3,6-Trimethylbenzoyl-diphenylphosphin
2,4,6-Trimethoxybenzoyl-diphenylphosphin
2,6-Dichlorbenzoyl-diphenylphosphin
2-Chlor-6-methylthio-benzoyldiphenylphosphin
2,6-Bis-(methylthio)-benzoyl-diphenylphosphin
2,3,4,6-Tetramethylbenzoyl-diphenylphosphin
2-Phenyl-6-methylbenzoyl-diphenylphosphin
1,3-Dimethylnaphthalin-2-carbonyl-diphenylphosphin
2,8-Dimethylnaphthalin-1-carbonyl-diphenylphosphin
1,3-Dimethoxynaphthalin-1-carbonyl-diphenylphosphin
1,3-Dichlornaphthalin-2-carbonyl-diphenylphosphin
2,4,6-Trimethylpyridin-3-carbonyl-diphenylphosphin
2,4-Dimethylfuran-3-carbonyl-diphenylphosphin
2,4-Dimethoxyfuran-3-carbonyl-di(n-butyl)phosphin
2,4,5-Trimethyl-thiophen-3-carbonyl-diphenylphosphin
2,4,5-Trimethyl-thiophen-3-carbonyl-diphenylphosphin
2,6-Dimethoxybenzoyl-bis-(p-tolyl)-phosphin
2,4,6-Trimethoxybenzoyl-bis-(o-tolyl)-phosphin
2,6-Dimethoxybenzoyl-bis-(p-chlorphenyl)-phosphin
2,4,6-Trimethoxybenzoyl-bis-(p-chlorphenyl)-phosphin
2,6-Dimethoxybenzoyl-di-tert.-butylphosphin
2,4,6-Trimethoxybenzoyl-di-tert.-butylphosphin

Die Herstellung derartiger Verbindungen kann beispielsweise nach folgenden drei Verfahren erfolgen :

1. Durch Umsetzen von Säurehalogeniden der allgemeinen Formel II

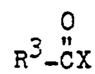

(II)

X = Cl, Br
mit Metallphosphiden der allgemeinen Formel (III)

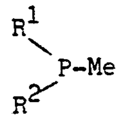

(III)

Me = Li, Na, K
zweckmäßigerweise in einem wasserfreien aprotischen Lösungsmittel in einer Inertgasatmosphäre von vorzugsweise Stickstoff, Argon oder Wasserstoff bei Temperaturen zwischen − 30 und 130 °C, bevorzugt zwischen − 10 und 100 °C. Bevorzugte Lösungsmittel sind Kohlenwasserstoffe wie Toluol, Cyclohexan oder Petroläther sowie aliphatische oder aromatische Äther wie Diäthyläther, Dibutyläther, Tetrahydrofuran, Dioxan, Diäthylenglykoldimethyläther, Diphenyläther. Die dabei entstehende Lösung des Acylphosphins kann durch Filtration oder durch Waschen mit Wasser vom gleichzeitig entstandenen Alkalihalogenid getrennt werden.

Nach Abdampfen des Lösungsmittels verbleibt das Acylphosphin, welches durch Destillation oder Umkristallisieren weiter gereinigt werden kann.

Dieses Herstellverfahren läßt sich folgendermaßen beispielhaft beschreiben :

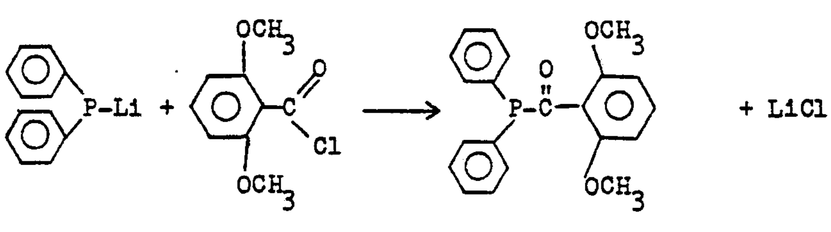

2. Durch Umsetzen eines Acylchlorides der Formel (II) mit einem Silylphosphin der allgemeinen Formel (IV)

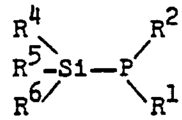

(IV)

wobei $R^4$, $R^5$, $R^6$ gleich oder verschieden sind und für $C_1$ bis $C_6$-Alkyl oder Phenylreste stehen ; bevorzugt sind Methyl- oder Äthylgruppen.

Diese Umsetzung wird zweckmäßigerweise in einem wasserfreien aprotischen Lösungsmittel in einer Inertgasatmosphäre von Stickstoff, Argon oder Wasserstoff bei Temperaturen zwischen − 30 und 130 °C, bevorzugt 0 bis 100 °C, durchgeführt. Bevorzugte Lösungsmittel sind die bei Verfahren 1 genannten. Das Acylphosphin fällt dabei entweder während der Reaktion als Niederschlag aus oder es verbleibt nach Abziehen des Lösungsmittels als Rückstand und kann durch Destillation oder Umkristallisieren weiter gereinigt werden.

Dieses Verfahren kann folgendermaßen beispielhaft beschrieben werden :

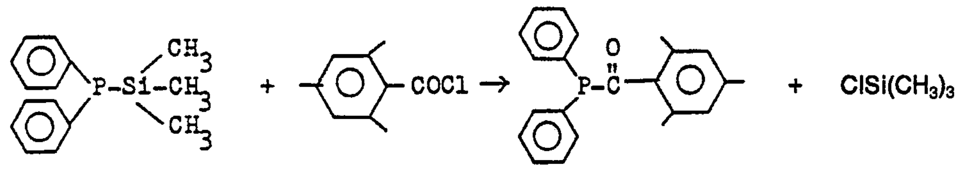

3. Durch Umsetzen eines Acylchlorides der allgemeinen Formel (II) mit einem Phosphin der allgemeinen Formel (V)

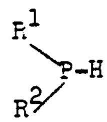

(V)

zweckmäßigerweise in Gegenwart von etwa äquimolaren Mengen tertiären Amins in einer Inertgasatmosphäre von Argon, Stickstoff oder Wasserstoff in einem Lösungsmittel wie einem Kohlenwasserstoff oder Kohlenwasserstoffgemisch wie Petroläther, Toluol, Cyclohexan, einem Äther oder anderen üblichen organischen Lösungsmitteln bei Temperaturen zwischen − 30 und + 130 °C bevorzugt bei 10 bis 100 °C. Geeignete tertiäre Amine sind z. B. Triäthylamin, Tributylamin, Diäthylanilin, Methyldiphenylamin.

Das entstehende Hydrochlorid des tertiären Amins kann durch Filtration oder durch eine Wäsche der organischen Phase mit Wasser abgetrennt werden. Aus der in dieser Weise erhaltenen Lösung des Acylphosphins kann dieses durch Abkühlen der Lösung oder durch Abziehen des Lösungsmittels als Rohprodukt gewonnen werden und durch Destillation, Umkristallisation oder Chromatographie weiter gereinigt werden.

Dieses Verfahren kann in folgender Weise beispielhaft beschrieben werden :

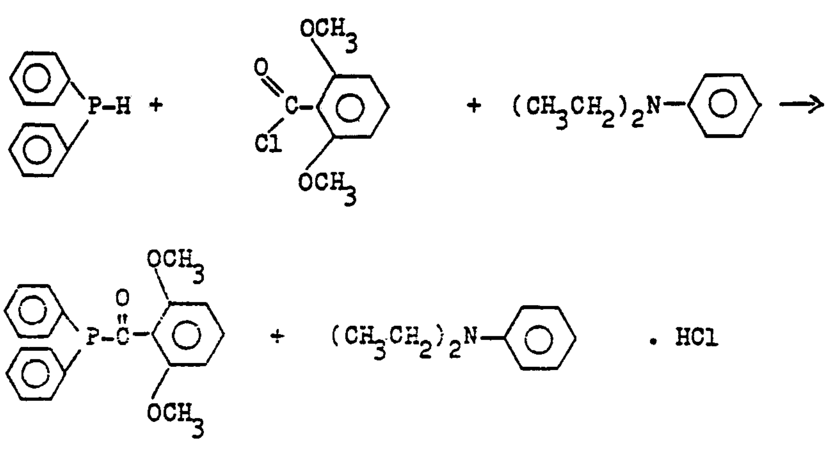

Bevorzugte Verfahren zur Herstellung der erfindungsgemäßen Aroylphosphine sind die Verfahren 1 und 2.

Die Gewinnung der Säurehalogenide $R^3$ COX (vgl. Weygand-Hilgetag, organisch-chemische Experimentierkunst, 4. Aufl., S. 246 bis 256 ; J. A. Barth-Verlag, Leipzig 1970), der Phosphine und ihrer Alkalisalze (vgl. K. Issleib und A. Tzschach, Chem. Ber. *92,* 704 (1959) ; K. Sasse in Houben-Weyl, Methoden der organischen Chemie, Bd. 12/1, S. 52 ff) sowie der Silylphosphine (vgl. K. Sasse, op. cit., S. 77) erfolgt nach Verfahren, die dem Fachmann aus der Literatur bekannt sind.

Als Ausgangsmaterialien geeignete Phosphine sind z. B. Dimethylphosphin, Dibutylphosphin, Diphenylphosphin, Bis-(p-tolyl)-phosphin, Di-tert.butylphosphin, Bis-(p-chlor-phenyl) phosphin ; geeignete Silylphosphine sind z. B. Verbindungen wie Trimethylsilyldimethylphosphin, Trimethylsilyldibutylphosphin, Trimethylsilyldiphenylphosphin, Triäthylsilyl-bis-(p-tolyl)-phosphin, Tripropylsilyl-di-tert.-butylphosphin. Geeignete Phosphide gehen aus den obengenannten Phosphinen hervor, wenn man das am Phosphor gebundene Wasserstoffatom durch Li, Na, K ersetzt.

Als Beispiele für die nach den erfindungsgemäßen Verfahren hergestellten neuen Acylphosphin-Verbindungen seien, folgende genannt :

Tabelle 1 : Beispiele der erfindungsgemäßen Acylphosphin-Verbindungen (Ph = Phenyl)

| Verbindung | Hergestellt nach Verfahren | Schmp. | Ausbeute | Analyse | C | H | P |
|---|---|---|---|---|---|---|---|
| 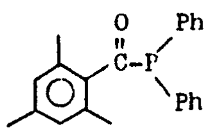 | 2 | 98° | 69 % | ber | 79,52 | 6,33 | 9,34 |
| | | | | gef | 79,1 | 6,27 | 8,98 |
| 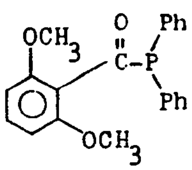 | 2 | 113 115° | 92 % | ber | 72,0 | 5,43 | 8,86 |
| | | | | gef | 71,5 | 5,4 | 8,7 |
| | 1 | 113-115° | 82 % | ber | 72,0 | 5,43 | 8,86 |
| | | | | gef | 71,7 | 5,4 | 8,8 |
| | 3 | 113-115° | 10 % | | | | |

Die erfindungsgemäßen Acylphosphinverbindungen zeigen eine sehr gute Reaktivität als Photoinitiatoren für photopolymerisierbare Monomere mit mindestens einer C-C-Mehrfachbindung und Mischungen derselben miteinander und mit bekannten Zusatzstoffen. Die erfindungsgemäßen Acylphosphinverbindungen eignen sich besonders gut als Photo-initiatoren in photopolymerisierbaren Massen für Überzüge und Lacke. Sie sind hinsichtlich der Vergilbung der so erhaltenen Lacke bzw. Überzüge bekannten Photoinitiatoren (z. B. dem aus der US-PS 3 668 093 bekannten Aroylphosphinen sowie Benzildimethylketal) weit überlegen. Die erfindungsgemäßen Acylphosphinverbindungen sind außerdem sehr vorteilhaft als Photoinitiatoren für die Lichthärtung von styrolischen Polyestern, die gegebenenfalls Glasfasern und andere Hilfsstoffe enthalten können, verwendbar.

Als photopolymerisierbare Monomere eignen sich die üblichen Verbindungen und Stoffe mit polymerisierbaren C-C-Doppelbindungen, die durch z. B. Aryl-, Carbonyl, Amino-, Amid-, Amido-, Ester-, Carboxy- oder Cyanid-Gruppen, Halogenatome oder C-C-Doppel- oder C-C-Dreifachbindungen aktiviert sind. Genannt seien beispielsweise Vinyläther und Vinylester, Styrol, Vinyltoluol, Acrylsäure und Methacrylsäure sowie deren Ester mit ein- und mehrwertigen Alkoholen mit bis zu 20, vorzugsweise 1 bis 8 Kohlenstoffatomen, deren Nitrile oder Amide, Malein- und Fumarester von Alkoholen mit 1 bis 20, vorzugsweise 1 bis 8 Kohlenstoffatomen sowie N-Vinylpyrrolidon, N-Vinylcaprolactam, N-Vinylcarbazol und Allylester wie Diallylpthalat.

Als photopolymerisierbare höhermolekulare Verbindungen sind beispielsweise geeignet : ungesättigte Polyester, hergestellt aus α,β-ungesättigten Dicarbonsäuren wie Maleinsäure, Fumarsäure oder Itaconsäure, gegebenenfalls im Gemisch mit gesättigten bzw. aromatischen Dicarbonsäuren wie Adipinsäure, Phthalsäure oder Terephthalsäure, durch Umsetzung mit Alkandiolen wie Äthylenglykol, Propylenglykol, Butandiol, Neopentylglykol oder oxalkyliertem Bisphenol A ; Epoxidacrylate, hergestellt aus Acryl- oder Methacrylsäure und aromatischen oder aliphatischen Diglycidyläthern und Urethanacrylate (z. B. hergestellt aus Hydroxyalkylacrylaten und Polyisocyanaten), sowie Polyesteracrylate (z. B. hergestellt aus hydroxylgruppenhaltigen gesättigten Polyestern und Acryl- oder Methacrylsäure).

Den photopolymerisierbaren Verbindungen, deren Zusammensetzung für den jeweiligen Verwendungszweck dem Fachmann geläufig ist, können in bekannter Weise gesättigte und/oder ungesättigte Polymere sowie weitere Zusatzstoffe wie Inhibitoren gegen die thermische Polymerisation, Paraffin, Pigmente, Farbstoffe, Peroxide, Verlaufshilfsmittel, Füllstoffe und Glasfasern sowie Stabilisatoren gegen thermischen oder photochemischen Abbau zugesetzt sein.

Solche Gemische sind dem Fachmann bekannt. Art und Menge der Zusätze hängen vom jeweiligen Verwendungszweck ab.

Die erfindungsgemäßen Acylphosphin-Verbindungen werden dabei im allgemeinen in einer Konzentration von 0,01 bis 15 Gew.-%, vorzugsweise von 0,1 bis 5 Gew.-%, bezogen auf die photopolymerisierbare Masse eingesetzt. Sie können gegebenenfalls mit Beschleunigern kombiniert werden, die den hemmenden Einfluß des Luftsauerstoffs auf die Photopolymerisation beseitigen.

Solche Beschleuniger bzw. Synergisten sind beispielsweise sekundäre und/oder tert. Amine wie Methyldiäthanolamin, Dimethyläthanolamin, Triäthylamin, Triäthanolamin, p-Dimethylaminobenzoesäureäthylester, Benzyl-dimethylamin, Dimethylaminoäthylacrylat, N-Phenylglycin, N-Methyl-N-phenylglycin und analoge, dem Fachmann bekannte Verbindungen. Zur Beschleunigung der Aushärtung können weiterhin aliphatische und aromatische Halogenide dienen wie 2-Chlormethylnaphthalin, 1-Chlor-2-chlormethyl-naphthalin sowie gegebenenfalls Radikalbildner wie Peroxide und Azo-Verbindungen, die in Mengen von bis zu 15 Gew.-%, bezogen auf die photopolymerisierbare Masse zugesetzt werden können.

Als Strahlungsquellen für das die Polymerisation solcher Mischungen auslösende Licht verwendet man solche, die Licht vorzugsweise im Absorptionsbereich der erfindungsgemäßen Verbindungen aussenden, d. h. zwischen 230 und 450 nm. Besonders geeignet sind Quecksilber-Niederdruckstrahler, -Mitteldruck- und Hochdruckstrahler sowie superaktinische Leuchtstoffröhren oder Impulsstrahler. Die genannten Lampen können gegebenenfalls dotiert sein.

Die in den nachstehenden Beispielen genannten Teile und Prozente beziehen sich, soweit nicht anders angegeben, auf das Gewicht. Volumenteile verhalten sich zu Teilen wie Liter zu Kilogramm. Soweit Lösungsmittel als « trocken » bezeichnet werden, wurden sie vor Einsatz über Natrium-Draht getrocknet.

## Beispiel 1

Es wird eine Suspension von 10 Teilen 2,6-Dimethoxybenzoylchlorid in 20 Volumenteilen trockenem Heptan hergestellt. Im Reaktionsgefäß wird dann durch zweimaliges Evakuieren und Füllen mit trockenem Stickstoff eine Inertgasatmosphäre hergestellt. Unter Rühren wird bei Raumtemperatur innerhalb von 30 Minuten eine Lösung aus 15.5 Teilen Trimethylsilyldiphenylphosphin in 30 Volumenteilen trockenem Heptan zugetropft. Nach zwanzigstündigem Rühren bei Raumtemperatur wird der Kolbeninhalt abgesaugt und getrocknet.

Ausbeute : 16,1 Teile 2,6-Dimethoxybenzoyldiphenylphosphin (92 % d. Th.)
Schmp. 113-115°
NMR ($CDCl_3$, δ) : 3,55 (s, 6H), 6,23 (d, 2H), 6,9-7,5 (m, 11H)
Analyse : $C_{21}H_{19}O_3P$(350)

| | | | |
|---|---|---|---|
| | C 72,0 | H 5,43 | P 8,86 |
| Gef. | C 71,5 | H 5,4 | P 8,7 |

## Beispiel 2

9,1 Teile 2,4,6-Trimethylbenzoesäurechlorid werden in 20 Volumenteilen trockenem Heptan gelöst vorgelegt und im Reaktionsgefäß durch zweimaliges Evakuieren und Füllen mit trockenem Stickstoff eine Inertgasatmosphäre hergestellt. Unter Rühren wird bei Raumtemperatur innerhalb von 30 Minuten eine Lösung von 15,5 Teilen Trimethylsilyldiphenylphosphin in 30 Volumenteilen trockenem Heptan zugetropft. Dann wird 72 Stunden bei Raumtemperatur nachgerührt. Der ausgefallene Niederschlag wird abgesaugt, mit wenig Heptan gewaschen und getrocknet.

Ausbeute : 11,5 Teile (69 % d. Th.)
Schmp. : 98 °C
NMR ($CDCl_3$, δ) : 2,06 (s, 6H), 2,20 (s, 3H), 6,68 (s, 2H) 7,2-7,7 (m, 10H)
MS : Molmasse 332
Analyse : $C_{22}H_{21}OP$(332)

| | | | |
|---|---|---|---|
| | C 79,52 | H 6,33 | P 9,34 |
| Gef. | C 79,1 | H 6,27 | P 8,98 |

## Beispiel 3

In einem Reaktionsgefäß wird durch zweimaliges Evakuieren und Befüllen mit Argon eine Inertgasatmosphäre hergestellt. Während der folgendenden Reaktionen wird im Reaktionsgefäß ein geringer Überdruck von Argon aufrecht erhalten. Das Reaktionsgefäß wird mit 10 Volumenteilen Diphenylphosphin und 50 Volumenteilen getrocknetem Tetrahydrofuran gefüllt und unter Rühren und Kühlung 38 Volumenteile einer 1.64-molaren Lösung von n-Butyl-Lithium in Hexan in 10 Minuten zugetropft, wobei eine tiefrote Lösung von Lithiumdiphenylphosphid erhalten wird. 10 Teile 2,6-Dimethoxybenzoylchlorid werden in 30 Volumenteilen trockenem Tetrahydrofuran gelöst und in der oben beschriebenen Weise eine Inertgasatmosphäre in dem Gefäß hergestellt. Zu dieser Lösung wird bei einer Innentemperatur von unter 20 °C unter Rühren, Eiskühlung und Inertgasatmosphäre die oben hergestellte Lösung von Lithiumdiphenylphosphid so lange tropfenweise zugegeben, bis die Lösung im Reaktionsgefäß nach Zugabe von 2-3 Tropfen länger als 5 Minuten eine deutlich rote Farbe zeigte. Dann wird 16 Stunden bei 25°C nachgerührt und anschließend der Inhalt des Reaktionsgefäßes in 300 Volumenteile Methylenchlorid und 100 Volumenteile gesättigte Ammoniumchloridlösung eingerührt. Die organische Phase wird dreimal mit je 200 Volumenteilen Wasser gewaschen, über Magnesiumsulfat getrocknet und zur Trockene eingeengt.

Ausbeute : 14,5 Teile (82,5 % d. Th.),
Schmp. : 113-115 °C
NMR : wie Beispiel 1
Analyse : $C_2H_{19}O_3$(350)

| | | | |
|---|---|---|---|
| | C 72,0 | H 5,43 | P 8,86 |
| Gef. | C 71,7 | H 5,4 | P 8,8 |

## Beispiel 4

Wie in Beispiel 3 wird im Reaktionsgefäß eine Inertgasatmosphäre hergestellt und 4,65 Teile Diphenylphosphin, 2,5 Teile Triäthylamin und 50 Volumenteile Diäthyläther vorgelegt. Bei 20 °C Innentemperatur wird unter Rühren eine Lösung von 5 Teilen 2,6-Dimethoxybenzoylchlorid in 10 Volumenteilen Äther zugetropft, anschließend 5 Stunden unter Rückfluß erhitzt und das ausgeschiedene Triäthylamin-Hydrochlorid abfiltriert. Nach Abziehen des Lösungsmittels wird ein öliges Rohprodukt erhalten, das durch Chromatographie an Kieselgel (Laufmittel Toluol/Äther 2 : 1) gereinigt wird.

Ausbeute : 1,7 Teile (10 % d. Th.),
Schmp. 113-115 °C
NMR : wie oben (Beispiel 1)

## Beispiel 5

Zur Messung der Härtungsaktivität der erfindungsgemäßen Verbindungen wurde der Temperaturverlauf im ungesättigten Polyesterharz (UP-Harz) während der UV-Belichtung aufgezeichnet ; dazu taucht ein mit einer Wachsschicht überzogener Thermofühler, der mit einem Temperaturschreiber (Tastotherm Script 3 N, Standardfühler T 300 der Deutschen Gulton GmbH) verbunden ist, in einen mit 10 g UP-Harz gefüllten Weißblechdeckel mit einem Durchmesser von 5 cm (Schichtdicke des UP-Harzes 4,8 mm). Zur Vermeidung von Wärmeverlusten während der UV-Belichtung ist der Deckel in Polyurethan-Hartschaum eingebettet. Als Strahlungsquelle dient ein UV-Feld aus 5 Leuchtstoffröhren (TLAK 40 W/05, Philips) nebeneinander. Der Abstand Strahler/UP-Harzoberfläche betrug 8,5 cm.

Aus den registrierten Temperatur-Zeitkurven werden als charakteristische Kenngrößen für die Härtungsaktivität die Härtungszeit HZ 25 °C-$T_{max}$ und die maximal erreichte Härtungstemperatur $T_{max}$ entnommen. Als Härtungszeit gilt die Zeitspanne, in der die Probentemperatur von 25 °C auf $T_{max}$ ansteigt.

Folgende Harze wurden dazu hergestellt :

### Harz A

Harz A ist eine mit 0,01 % Hydrochinon stabilisierte 65 %ige styrolische Lösung eines ungesättigten Polyesters aus Maleinsäure, o-Phthalsäure, Äthylenglykol und Propylenglykol-1,2 im Molverhältnis 1 : 2 : 2,3 : 0,70. Der ungesättigte Polyester hat eine Säurezahl von 50.

### Harz B

Harz B ist eine mit 0,01 % Hydrochinon stabilisierte 66 %ige styrolische Lösung eines ungesättigten Polyesters aus Maleinsäure, o-Phthalsäure und Propylenglykol-1,2 im Molverhältnis 1 : 0,5 : 1;5. Der ungesättigte Polyester hat eine Säurezahl von 50.

### Harz C

Harz C ist eine mit 0,01 % Hydrochinon stabilisierte 72 %ige styrolische Lösung eines ungesättigten Polyesters aus Maleinsäure, Propylenglykol und Dipropylenglykol im Molverhältnis 1 : 0,78 : 0,33.

(Siehe Tabelle 2 Seite 8 f.)

Tabelle 2 : Temperaturverlauf während der Photopolymerisation

| lfd. Nr. | Photoinitiator | Konzentration | UP-Harz | Härtung vor Lagerung Härtungszeit $HZ_{25^oC-T_{max}}$ | Härtung vor Lagerung maximale Proben-Temperatur $T_{max}$ ($^oC$) | Farbe des Formstoffs |
|---|---|---|---|---|---|---|
| 1 | 2,4,6-Trimethyl-benzoyldiphenyl-phosphin | 0,2 % | A | 4 min 15 s | 112 | farblos |
| | | 0,1 % | A | 4 min 8 s | 109 | farblos |
| | | 0,2 % | B | 3 min 23 s | 125 | farblos |
| | | 0,2 % | C | 3 min 8 s | 121 | gelblich |
| 2 | 2,6-Dimethoxy-benzoyldiphenyl-phosphin | 0,2 % | A | 5 min 25 s | 110 | farblos |
| 3 | Benzoyldiphenyl-phosphin | 0,2 % | A | 31 min | 43 | gelb |
| 4 | p-Dimethylamino-benzoyldiphenyl-phosphin | 0,2 % | A | 20 min | 42 | gelb |
| 5 | Benzildimethylketal | 0,2 % | A | 8 min | 114 | gelb |
| 6 | Benzoiniso-propyläther | 0,2 | A | 13 min 22 s | 104 | gelb |
| 7 | Methylolbenzoin-methyläther | 0,2 | B | 13 min 22 s | 100 | gelb |

Die mit diesen Harzen erhaltenen Meßwerte sind in Tabelle 2 zusammengefaßt. Danach zeichnen sich die erfindungsgemäßen Initiatoren (lfd. Nr. 1,2) gegenüber dem Stand der Technik (lfd. Nr. 3-7) durch schnellere Härtung und geringere Vergilbung der damit hergestellten Formstoffe aus.

Beispiel 6

In einem Bindemittel aus 65 Teilen eines Umsetzungsproduktes aus Bisphenol-A-gycidäther und Acrylsäure, 35 Teilen Hexan-1,6-dioldiacrylat werden 3 Teile Photoinitiator gelöst. Die fertige Mischung wird auf Glasplatten in einer Schicht von 60µ Dicke aufgerackelt und in 10 cm Abstand unter einer Quecksilberhochdurcklampe (Leistung 80 W/cm Bogenlänge) vorbeigeführt. Die Reaktivität ist als die maximal mögliche Transportbandgeschwindigkeit angegeben, bei der noch eine nagelharte kratzfeste Aushärtung des Überzuges erzielt wird.

Tabelle 3

| Photoinitiator | maximale Transportbandgeschwindigkeit in m/min unter Luft | unter Inertgas | unter Luft, Zusatz 3 % Methyldiäthanolamin | Farbe des gehärteten Lackfilms |
|---|---|---|---|---|
| 2,4,6-Trimethyl-benzoyl-diphenyl-phosphin | 13 | 72 | 38 | farblos |
| 2,6-Dimethoxybenzoyl-diphenylphosphin | < 12 | 72 | 38 | farblos |
| Benzoyldiphenylphosphin + | < 12 | < 12 | 12 | gelblich |
| p-Dimethylaminobenzoyl-diphenylphosphin + | 12 | 12 | 12 | intensiv gelb |

(*) Vergleich nach US-PS 3 668 093

Die Ergebnisse in Tabelle 3 zeigen, daß die erfindungsgemäßen Acylphosphin-Verbindungen den in der US-PS 3 668 093 beschriebenen Acylphosphin-Verbindungen bezüglich Vergilbung und Reaktivität überlegen sind.

Beispiel 7

Zu einem nach Beispiel 6 hergestellten Lack werden 3 % Methyldiäthanolamin gegeben. Anschließend wird wie in Beispiel 6 auf Glasplatten aufgezogen und belichtet. Die Ergebnisse sind in Tabelle 3 zusammengefaßt. Im Gegensatz zu den Verbindungen der US-PS 3 668 093 läßt sich die Härtung der erfindungsgemäßen Verbindungen an Luft durch Zusatz eines Aminbeschleunigers beschleunigen.

**Ansprüche**

1. Acylphosphin-Verbindungen der allgemeinen Formel (I)

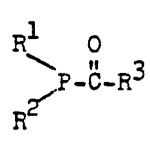

(I)

worin

$R^1$ für einen geradkettigen oder verzweigten Alkylrest mit 1 bis 6 Kohlenstoffatomen, den Cyclohexyl-, Cyclopentyl-, Phenyl-, einen Naphthyl-, einen halogen-, $C_1$ bis $C_4$-alkyl- oder $C_1$ bis $C_4$-alkoxy-substituierten Phenyl- oder Naphthylrest oder einen S- oder N-haltigen fünf- oder sechsgliedrigen heterocyclischen Ring steht;

$R^2$ die Bedeutung von $R^1$ hat, wobei $R^1$ und $R^2$ untereinander gleich oder verschieden sein können oder $R^1$ und $R^2$ miteinander zu einem Ring verknüpft sind, der 4 bis 10 Kohlenstoffatome enthält und durch 1 bis 6 weitere Alkylreste mit je 1 bis 4 Kohlenstoffatomen substituiert sein kann sowie 1 oder 2 ankondensierte Benzolringe besitzen kann,

$R^3$ für einen mindestens zweifach substituierten Phenyl-, Pyridyl-, Furyl-, Pyrrolyl- oder Thienylrest steht, der mindestens an den beiden zur Verknüpfungsstelle mit der Carbonylgruppe benachbarten Kohlenstoffatomen die Substituenten A und B trägt, die untereinander gleich oder verschieden sein können und für 1 bis 6 Kohlenstoffatome enthaltende Alkyl-, Alkoxy- oder Alkylthioreste, 3 bis 7 Kohlenstoffatome enthaltende Cycloalkylreste, Phenylreste oder Halogen-, vorzugsweise Chlor- oder Bromatome stehen oder $R^3$ für einen mindestens in den 2,8-Stellungen durch A und B substituierten α-Naphthylrest oder einen mindestens in 1,3-Stellungen durch A und B substituierten β-Naphthylrest oder für die Gruppierung

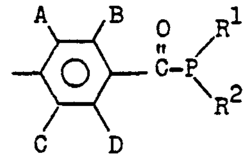

steht, wobei die Reste A, B, C und D untereinander gleich oder verschieden sind und C und D die gleiche Bedeutung haben wie A und B.

2. Verfahren zur Herstellung der Acylphosphine nach Anspruch 1 dadurch gekennzeichnet, daß Säurehalogenide der allgemeinen Formel (II),

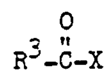 (II)

worin X für Cl oder Br steht und $R^3$ die obengenannte Bedeutung hat, in Gegenwart eines inerten Lösungsmittels bei Temperaturen zwischen – 30 und 110 °C mit einem Phosphid der allgemeinen Formel (III),

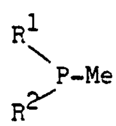 (III)

worin $R^1$ und $R^2$ die obengenannte Bedeutung haben und Me für die Alkalimetalle Li, Na oder K steht, umgesetzt werden.

3. Verfahren zur Herstellung der Acylphosphine nach Anspruch 1, dadurch gekennzeichnet, daß Säurehalogenide der allgemeinen Formel (II) bei Temperaturen zwischen – 10° und 130 °C, gegebenenfalls in einem inerten organischen Lösungsmittel mit einem Silylphosphin der allgemeinen Formel (IV)

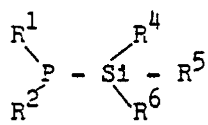 (IV)

umgesetzt werden, worin $R^1$ und $R^2$ die unter Anspruch 1 angegebene Bedeutung haben und $R^4$, $R^5$, $R^6$ gleich oder verschieden sind und für $C_1$ bis $C_6$-Alkyl- oder Phenylreste, stehen.

4. Verfahren zur Herstellung der Acylphosphine nach Anspruch 1, dadurch gekennzeichnet, daß Säurehalogenide der allgemeinen Formel (II) mit Phosphinen der allgemeinen Formel (V),

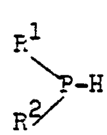 (V)

worin $R^1$ und $R^2$ die unter Anspruch 1 genannte Bedeutung haben, in Gegenwart von etwa äquimolaren Mengen eines tertiären Amins bei Temperaturen zwischen – 10° und 200 °C in einem inerten Lösungsmittel umgesetzt werden.

5. Verfahren nach Anspruch 2, dadurch gekennzeichnet, daß das Metallphosphid der allgemeinen Formel (III) in einem inerten organischen Lösungsmittel in an sich bekannter Weise erzeugt und ohne Isolierung weiter umgesetzt wird.

6. Verwendung der Acylphosphine nach Anspruch 1, als Photoinitiatoren in photopolymerisierbaren Massen.

7. Verwendung der Acylphosphine nach Anspruch 1 in Kombination mit sekundären und/oder tertiären Aminen als Photoinitiatoren in photopolymerisierbaren Massen.

8. Verwendung nach Anspruch 6 oder 7 zur Herstellung von Überzügen oder Imprägnierungen.

9. Verwendung nach Anspruch 6 oder 7 zur Herstellung von Kunststoff-Formteilen auf Basis ungesättigter Polyesterharze, die gegebenenfalls weitere Hilfsstoffe, insbesondere Glasfasern, enthalten.

**Claims**

1. An acyl phosphine compound of the general formula (I)

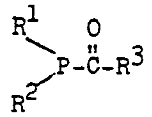

(I)

where

$R^1$ is a linear or branched alkyl of 1 to 6 carbon atoms ; cyclohexyl, cyclopentyl or phenyl ; phenyl or naphthyl substituted by naphthyl, halogen, alkyl of 1 to 4 carbon atoms or alkoxy of 1 to 4 carbon atoms ; or an S- or N-containing, five- or six-membered heterocyclic ring ;

$R^2$ has the same meanings as $R^1$, $R^1$ and $R^2$ being identical or different, or $R^1$ and $R^2$ are linked together to form a ring which contains 4 to 10 carbon atoms and may be substituted by further alkyls each having 1 to 4 carbon atoms, and may possess 1 or 2 fused benzene rings ; and

$R^3$ is an at least disubstituted phenyl, pyridyl, furyl, pyrrolyl or thienyl which bears substituents A and B at least on the two carbon atoms adjacent to the point of attachment to the carbonyl group, which substituents may be identical or different and be alkyl, alkoxy or alkylthio each having 1 to 6 carbon atoms, cycloalkyl of 3 to 7 carbon atoms, phenyl, or halogen, preferably chlorine or bromine, or $R^3$ denotes α-naphthyl substituted by A and B at least in the 2- and 8-positions, or β-naphtyl substituted by A and B at least in the 1- and 3-positions, or the group

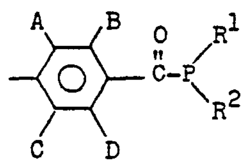

the radicals A, B, C and D being identical or different, and C and D having the same meanings as A and B.

2. A process for the preparation of an acyl phosphine as claimed in claim 1, wherein an acid halide of the general formula (II)

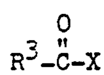

(II)

where X is chlorine or bromine, and $R^3$ has the above meanings, is reacted with a phosphide of the general formula (III)

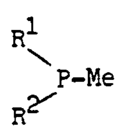

(III)

where $R^1$ and $R^2$ have the above meanings and Me stands for one of the alkali metals Li, Na and K, in the presence of an inert solvent at a temperature of from − 30 to + 110 °C.

3. A process for the preparation of an acyl phosphine as claimed in claim 1, wherein an acid halide of the general formula (II) is reacted with a silyl phosphine of the general formula (IV)

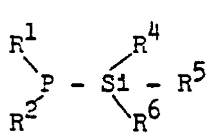

(IV)

where $R^1$ and $R^2$ have the meanings given in claim 1, and $R^4$, $R^5$ and $R^6$ are identical or different and each denotes alkyl of 1 to 6 carbon atoms, or phenyl, at a temperature of from − 30 to + 130 °C in the presence or absence of an inert organic solvent.

4. A process for the preparation of an acyl phosphine as claimed in claim 1, wherein an acid halide of the general formula (II) is reacted with a phosphine of the general formula (V)

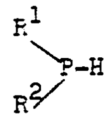

(V)

where $R^1$ and $R^2$ have the meanings given in claim 1, in the presence of an approximately equimolar amount of a tertiary amine at a temperature of from − 10 to + 200 °C in an inert solvent.

5. A process as claimed in claim 2, wherein the metal phosphide of the general formula (III) is produced in an inert organic solvent in a conventional manner, and further reacted without being isolated.

6. The use of an acyl phosphine as claimed in claim 1 as a photoinitiator in photopolymerizable compositions.

7. The use of an acyl phosphine as claimed in claim 1 in conjunction with a secondary and/or tertiary amine, as a photoinitiator in photopolymerizable compositions.

8. The use as claimed in claim 6 or 7 for the production of coatings or impregnations.

9. The use as claimed in claim 6 or 7 for the production of plastics moldings based on unsaturated polyester resins which may, if desired, contain further auxiliaries, particularly glass fibers.

**Revendications**

1. Dérivés d'acyl-phosphines de la formule générale (I)

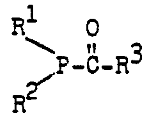

(I)

dans laquelle

$R^1$ désigne un groupe alkyle à chaîne droite ou ramifiée en $C_1$ à $C_6$, un groupe cyclohexyle ou cyclopentyle, un groupe phényle ou naphtyle éventuellement halo-, alkyl(en $C_1$ à $C_4$)- ou alcoxy(en $C_1$ à $C_4$)-substitué ou un noyau hétérocyclique penta- ou hexagonal avec des atomes de soufre ou d'azote ;

$R^2$ possède les mêmes significations que $R^1$, $R^1$ et $R^2$ pouvant être identiques ou différents, ou $R^1$ et $R^2$ forment ensemble un noyau cyclique avec 4 à 10 atomes de carbone, éventuellement substitué par 1 à 6 radicaux alkyle en $C_1$ à $C_4$ additionnels, et sur lequel peuvent être condensés un ou deux noyaux benzéniques ;

$R^3$ représente un groupe phényle, pyridyle, furyle, pyrrolyle ou thiényle portant au moins deux substituants et portant au moins, sur les deux atomes de carbone adjacents au point de liaison du groupe carbonyle, des substituants A et B, qui peuvent être identiques ou différents et sont choisis parmi les groupes alkyle, alcoxy et alkyl-thio en $C_1$ à $C_6$, les groupes cycloalkyle en $C_3$ à $C_7$, le groupe phényle et les atomes d'halogène, de préférence des atomes de chlore ou de brome, ou $R^3$ représente un groupe α-naphtyle substitué au moins sur les positions 2 et 8 par A et B ou un groupe β-naphtyle substitué au moins sur les positions 1 et 3 par A et B ou un groupement de la formule

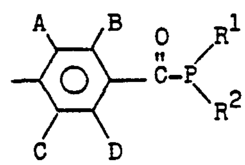

dans laquelle A, B, C et D peuvent être identiques ou différents, C et D possédant les mêmes significations que A et B.

2. Procédé de préparation d'acyl-phosphines selon la revendication 1, caractérisé en ce que l'on fait réagir un halogénure d'acide de la formule générale (II)

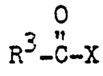

(II)

dans laquelle X désigne un atome de chlore ou de brome et $R^3$ possède la signification définie ci-dessus,

dans un solvant inerte et à des températures entre − 30 et 110 °C, avec un phosphure de la formule générale (III)

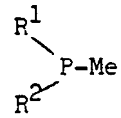

(III)

dans laquelle $R^1$ et $R^2$ possèdent la signification définie ci-dessus et Me désigne l'un des métaux alcalins Li, Na ou K.

3. Procédé de préparation d'acyl-phosphines selon la revendication 1, caractérisé en ce que l'on fait réagir un halogénure d'acide de la formule générale (II) à des températures entre − 10 °C et 130 °C, le cas échéant dans un solvant organique inerte, avec une silyl-phosphine de la formule générale (IV)

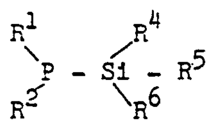

(IV)

dans laquelle $R^1$ et $R^2$ possèdent la signification définie dans la revendication 1 et $R^4$, $R^5$ et $R^6$, qui peuvent être identiques ou différents, désignent des groupes alkyle en $C_1$ à $C_6$ ou phényle.

4. Procédé de préparation d'acyl-phosphines selon la revendication 1, caractérisé en ce que l'on fait réagir un halogénure d'acide de la formule générale (II) dans un solvant inerte, en présence d'une proportion approximativement équimolaire d'une amine tertiaire et à des températures entre − 10 °C et 200 °C, avec une phosphine de la formule générale (V)

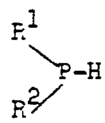

(V)

dans laquelle $R^1$ et $R^2$ possèdent la signification définie dans la revendication 1.

5. Procédé suivant la revendication 2, caractérisé en ce que le phosphure de métal de la formule générale (III) est préparé de manière connue en soi dans un solvant organique inerte et utilisé sans isolement dans la réaction subséquente.

6. Utilisation des acyl-phosphines selon la revendication 1 comme photo-initiateurs dans des matières photo-polymérisables.

7. Utilisation des acyl-phosphines selon la revendication 1, en combinaison avec des amines secondaires et (ou) tertiaires, comme photo-initiateurs dans des matières photo-polymérisables.

8. Utilisation selon la revendication 6 ou la revendication 7 pour la réalisation de revêtements ou d'imprégnations.

9. Utilisation selon la revendication 6 ou la revendication 7 pour la fabrication d'éléments façonnés en matières plastiques à base de résines de poly-esters non saturés, pouvant éventuellement contenir d'autres additifs, en particulier des fibres de verre.